# EUROPEAN PATENT SPECIFICATION

(11) **EP 3 566 311 B1**
(45) Date of publication and mention of the grant of the patent: **15.03.2023**
(21) Application number: 17721459.0
(22) Date of filing: 16.03.2017
(51) Int. Cl.: H03M 1/46, H03M 1/80

(54) **SAR ADC WITH THRESHOLD TRIGGER FUNCTIONALITY FOR REDUCED POWER CONSUMPTION**
SAR ADC MIT SCHWELLENAUSLÖSEFUNKTIONALITÄT FÜR REDUZIERTEN STROMVERBRAUCH
CAN SAR AYANT UNE FONCTIONNALITÉ DE DÉCLENCHEMENT DE SEUIL POUR UNE CONSOMMATION D'ÉNERGIE RÉDUITE

(30) Priority: 06.01.2017 US 201715400513
(43) Date of publication of application: 13.11.2019
(73) Proprietor: Disruptive Technologies Research AS, 1366 Lysaker (NO); Moldsvor, Oystein, 7092 Tiller (NO)
(72) Inventor: HERNES, Bjørnar, 7020 Trondheim (NO)
(74) Representative: Sach, Greg Robert
(86) International application number: PCT/IB2017/000335
(87) International publication number: WO 2018/127723

(56) References cited:
- US-A- 6 075 478
- US-A1- 2010 271 250
- US-A1- 2013 194 121

## Description

### Technical Field

The present disclosure relates generally to analog-to-digital converters (ADCs) and, more particularly, to systems and methods for performing Successive-approximation-register (SAR) ADC in a sensor node device.

### Background

In battery-powered electronic devices, power dissipation is an important consideration; power dissipation affects both battery life and device heat levels. Further, wireless sensor devices often include analog-to-digital converters (ADCs) for digitizing sensor outputs and it becomes important to reduce the power dissipation of each ADC to reduce the overall power consumption of the device. In the last decade, the SAR (Successive-approximation-register) ADC has become popular due to its low power dissipation and scalability with finer process geometries.

Typically, sensor readout systems measure when the sensor output crosses a certain threshold level. This is generally done by digitizing the sensor output and performing a comparison in the digital domain. However, even when using SAR ADC technology, this still consumes appreciable power.

The present disclosure is directed to addressing one or more deficiencies and/or disadvantages, e.g., as set forth above or otherwise. However, it should be appreciated that the solution of any particular problem is not a limitation on the scope of this disclosure or of the attached claims except to the extent expressly noted. Moreover, this Background section reflects the inventors' thoughts and is not intended to accurately or completely reflect any particular prior art. As such, Applicants expressly disclaim this material as admitted prior art. US2013194121 discloses a data acquisition circuit including an analog multiplexer to receive analog signals and select an analog signal for output, an ADC coupled to the multiplexer to receive the analog signal and perform a conversion of the analog signal to a N-bit digital value in at least N clock cycles, and a controller coupled to the ADC to enable the ADC to compare the analog signal to a second analog signal in a single clock cycle. US2010271250 discloses an analog to digital converter (ADC) component with a comparator function for analog signals. US6075478 discloses a successive approximation analog/digital ("A/D") converter that converts an analog input voltage to a digital value for output in a manner enabling a reduction in power consumption. The A/D converter includes a comparator that outputs a referencing result signal by comparing an analog input voltage against a reference voltage. A D/A converter outputs the reference voltage to a comparator in correspondence to a digital voltage signal. A successive approximation register outputs the digital voltage signal to the D/A converter in correspondence to a conversion control signal. A conversion control device outputs the conversion control signal to the successive approximation register in correspondence to the referencing result signal to continue operation of the AND converter until the difference between the analog input voltage and the reference voltage converges to within a specific tolerance range. An output unit holds the digital voltage signal from the successive conversion register at a point in time at which the difference has converged to within the tolerance range and outputs the digital voltage signal as a digital output signal.

### Summary of the Disclosure

The present invention is defined in the appended claims.

Other aspects and features will be more readily understood when reading the following detailed description in conjunction with the accompanying drawings.

### Brief Description of the Drawings

Figure 1 is a schematic drawing of an implementation of an SAR ADC;
Figure 2 is an indexed signal plot showing example signal values during operation of the SAR ADC of Figure 1;
Figure 3 is a schematic drawing of an implementation of an SAR ADC in accordance with the invention;
Figure 4 is an indexed signal plot showing example signal values during operation of the SAR ADC of Figure 3; and
Figure 5 is a flow chart showing an ADC process in accordance with the invention.

### Detailed Description

Before turning to a detailed discussion of the figures, a brief overview of certain disclosed features and principles will be given to aid the reader. As noted above, the ADC is often an integral part of sensor circuits, and the SAR ADC is increasingly used in this application. However, ADCs, including SAR ADCs, can consume or dissipate a significant amount of electrical power, and any energy savings in the SAR ADC will inure to the benefit of the device user in terms of lower heat and longer battery life. As such, according to the invention, a threshold trigger functionality for reduced power consumption is implemented.

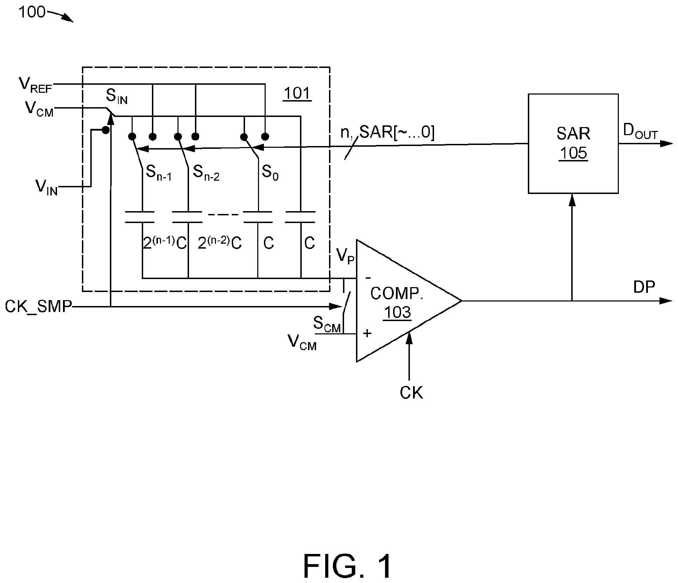

Referring to Fig. 1, this figure shows a simplified schematic representation of an SAR ADC. For simplicity the figure shows a single-ended system, while many implementations may be differential in order to resist noise in the circuit. While the illustrated circuit is a principal implementation of a SAR ADC, there exist a range of different implementations and the principles presented herein can be applied to any implementations that are based on charge conservation in the ADC.

The illustrated circuit 100 includes a DAC 101, a comparator 103, and an SAR 105. The circuit modes of operation include a track phase, a sampling phase and a conversion phase. In the tracking phase, CK_SMP is low, *S_{IN}* and *S_{CM}* are closed (conducting) and the input voltage *V_{IN}* is applied over all capacitors in the capacitor array of the DAC. In the sampling phase, on rising edge of CK_SMP, the switches *S_{IN}* and *S_{CM}* open, and a sample of *V_{IN}* is stored over the capacitor array of the DAC.

In the conversion phase, a number of steps are executed. The SAR algorithm starts by connecting the MSB switch *Sₙ₋ₗ* to *V_{REF}* while the rest of the switches *Sn-₂-S₀* are connected to *V_{CM}.* This is done by setting the MSB bit of the SAR[]-bus to 1 and the rest of the bits to 0. The comparator COMP 103 is now clocked by the rising edge of CK and the voltage VP is compared to the common mode voltage *V_{CM}.* If VP > *V*_{CM} then DP is set to 1 and MSB in the SAR[]-bus is maintained 1. If VP < *V_{CM}* then DP is set to 0 and MSB in the SAR[]-bus is set to 0.

The MSB-1 bit in the SAR[]-bus is set and the procedure above is repeated until bit 0 of the SAR[]-bus is evaluated and set accordingly. The result is now made available at the ADC digital output *Dₒᵤₜ.*

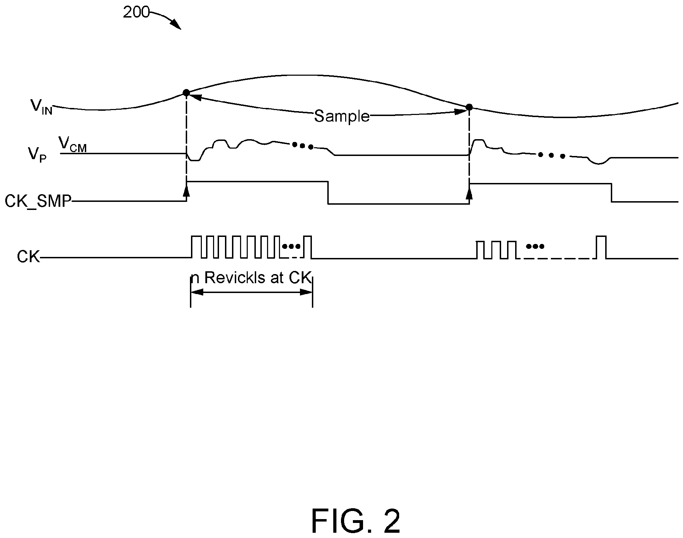

The indexed signal plot of Figure 2 shows the signal values in an example during the foregoing phases.

In case of threshold comparison, the output word *Dₒᵤₜ* can now be compared to one or more threshold values in the digital domain. The power dissipation for such an ADC is strongly dependent on the number of clock cycles of CK, which is equal to number of bits in *Dₒᵤₜ.* Additional power is consumed during the comparison to the threshold values in the digital domain.

According to the invention, the comparison to the digital threshold values is executed directly in the analog domain, without resolving the output word *Dₒᵤₜ.* This means that the number of comparisons, and thus the numbers of required periods of CK, equals number of threshold values instead of equaling the number of bits in the resolved output word. In this way, power is saved in the analog domain as well as in the digital domain.

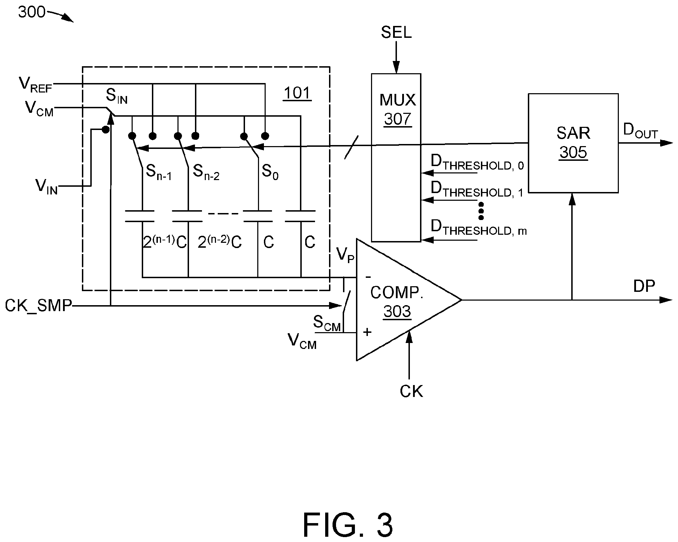

A simplified schematic of an SAR DAC in accordance with the invention is shown in Figure 3. The only addition to the figure above is the MUX that can select between the ordinary output of the SAR or one of M+1 threshold values *D*_{*THRESHOLD,*0} to *D*_{*THRESHOLD,*M}*,* each given as an n-bit digital word. The selection is done by the digital signal SEL. When the circuit is operated as an ordinary SAR ADC, the MUX selects the output the SAR as the input to the capacitor DAC, and goes through the number of cycles necessary to resolve the n-bit output word *Dₒᵤₜ.* The procedure for resolving the n-bit output word is as explained above.

As noted above, the comparison of values to one of the digital threshold values can be executed in three phases, e.g., a track phase, a sampling phase and a comparison stage. During the track phase, CK_SMP is low, *S_{IN}* and *S_{CM}* are closed (conducting) and the input voltage *V_{IN}* is applied over all capacitors in the capacitor array of the DAC. During the sampling phase, *S_{IN}* and *S_{CM}* open on the rising edge of CK_SMP, and a sample of *V_{IN}* is stored over the capacitor array of the DAC.

Finally, in the comparison phase, SEL is set such that the MUX selects the n-bit threshold value *D*_{*THRESHOLD,*0} which is applied to the DAC capacitor array. All switches *Sᵢ,* where *i* is in the range from *0* to *n-1,* which receive 1 connect to VREF. The remaining switches connect to *V_{CM}.* The value of *VP* will reach a value equal to the input voltage *V_{IN}* subtracted from the analog version of *D_{THRESHOLD.0}.* The comparison to VCM is now done at the rising edge of CK by the comparator COMP.

If VP > *V_{CM},* then DP is set to 1 and the sample of *V_{IN}* is larger than *D_{THRESHOLD.0}.* On the other hand, if VP < *V_{CM},* then DP is set to 0 and the sample of *V_{IN}* is smaller than *D_{THRESHOLD.0}.* The follow-up action can now be taken.

Since the charge stored at the capacitors in the DAC capacitor array is conserved, a new comparison to one of the other *D_{THRESHOLD,j},* where j is in the range from *1* to *M,* can be performed by changing SEL such that new threshold value is selected for the next comparison occurring at the next rising edge of CK.

After any number of *D_{THRESHOLD,j}* comparisons, a full SAR conversion is carried out on the same input sample. This is done as a result of one of the threshold conversions. If the sampled *V_{IN}* has crossed a threshold level, a full resolution digital value of the sample is required.

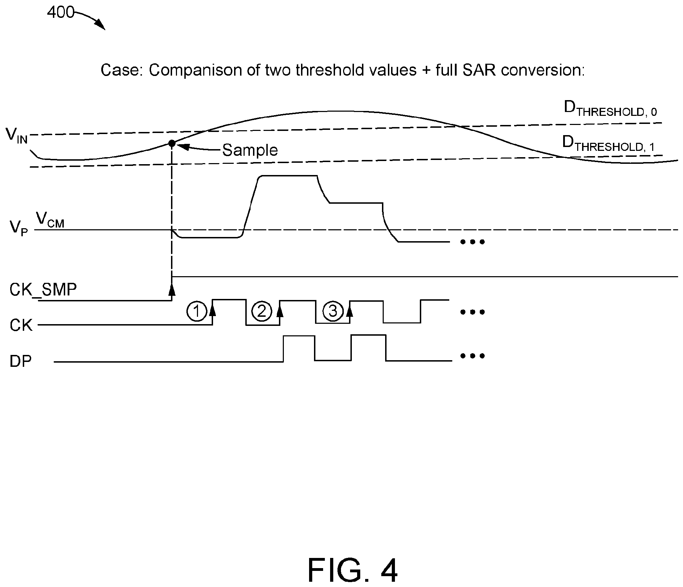

Figure 4 shows the input voltage *V_{IN},* the comparator COMP input voltage *V_{P}*, and the waveforms of CK SMP, CK and DP. First *V_{IN}* is sampled at the rising edge of CK_SMP. Then *D*_{*THRESHOLD,*0} is chosen and compared at the first rising edge of CK (denoted 1). The comparison result on DP is 0 since the sampled *V_{IN}* is less than the equivalent analog value of *D_{THRESHOLD.1}.* Further, *D*_{*THRESHOLD,*0} is applied to the DAC, and the comparison is carried out at the 2nd rising edge of CK, denoted 2. DP becomes 1 since the sample of *V_{IN}* is larger than the equivalent analog value of *D_{THRESHOLD.1}.* On the 3rd rising edge of CK (denoted 3), a full SAR conversion is started and after *n* additional clock cycles of CK, the n-bit word *D_{OUT}* is ready at the ADC output.

To facilitate ultra-long battery life in sensor systems, power must be conserved. To this end, power-efficient sensor readout circuits are beneficial. The described principles conserve power by executing the threshold comparison in the analog domain and by requiring fewer conversion cycles for a full SAR conversion. Executing the threshold comparison directly in the analog domain saves both digital circuitry and electric power versus executing the comparison digitally.

In an embodiment of the disclosed principles, the input voltage *V_{IN}* is sampled, and the sample is compared to a pre-defined digital threshold value *D_{THRESHOLD.0}.* The result DP of the comparison is used as an input to a sensor baseline tracking algorithm, tracking low speed changes due to environment parameters other than the parameter the sensor system is intended to monitor, which is assumed to be high speed.

The baseline algorithm can force a full SAR conversion, on the same sample of the input voltage *V_{IN},* due to the value of DP obtained in this comparison and/or together with previous comparisons between *D_{THRESHOLD.0}* to previous samples of the voltage *V_{IN}.* The digital threshold value *D*_{*THRESHOLD,*0} is then updated in accordance with a baseline algorithm and previous results of comparison between previous samples of *V_{IN},* and/or full SAR conversions.

In another embodiment of the described principles, a 2nd comparison of the same sample of *V_{IN}* is made to a 2nd pre-defined digital threshold *D_{THRESHOLD.1}* and the result DP of the comparison is then used as a threshold trigger for a full SAR conversion of the same sample of *V_{IN},* to obtain a full resolution quantization of the sensor output. In a further embodiment, the value of *D_{THRESHOLD.1}* is used as an offset *D_{OFFSET,1}* away from the baseline threshold *D*_{*THRESHOLD,*0} and *D_{THRESHOLD,1}* may be updated with *D_{OFFSET.1}* + *D_{THRESHOLD,0}* when the baseline tracking algorithm updates *D_{THRESHOLD.0}.*

In another embodiment of the described principles, a 3rd comparison is performed of the same sample of *V_{IN}* to a 3rd pre-defined digital threshold value *D_{THRESHOLD,2}* and the result DP is applied as a threshold trigger to a full SAR conversion of the same sample of VIN to obtain a full resolution of the sensor output. Similar to the above embodiment, the value of *D_{THRESHOLD,2}* could be an offset *D_{OFFSET,2} (D_{OFFSET,2} ≠ D_{OFFSET,1})* away from the baseline threshold *D_{THRESHOLD,0}, and D_{THRESHOLD,2}* may be updated *with D_{OFFSET,2} + D_{THRESHOLD,0}* when the baseline tracking algorithm updates *D_{THRESHOLD,0}.*

The processes described herein may be executed by controlling a circuit such as that shown in the figures, via a processor or controller executing computer-executable instructions read from a non-transitory computer-readable medium. Those of skill in the art will appreciate that many computer-readable medium exist, including optical and magnetic memory media, flash memory media, and so on.

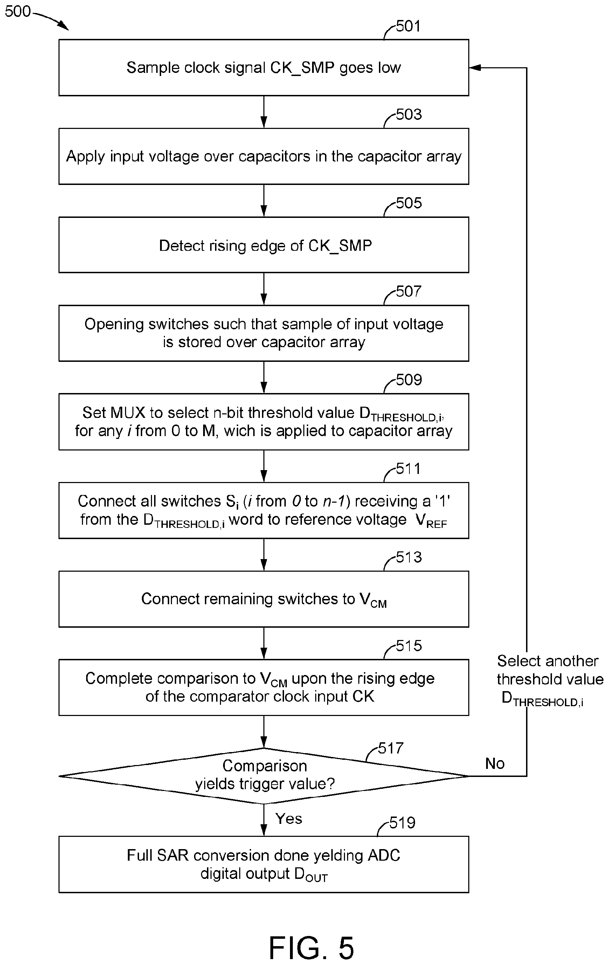

Although the steps of such a method may be executed in various ways, Figure 5 is a flow chart showing exemplary steps in an illustrative embodiment. The process 500 begins at stage 501 of the illustrated process 500, when a sample clock signal CK_SMP goes low. A track phase then begins at stage 503 by applying an input voltage *V_{IN}* over all capacitors in the capacitor array of the ADC. At stage 505, a subsequent rising edge of CK_SMP is detected and a sampling phase is executed at stage 507 by opening the switches such that a sample of *V_{IN}* is stored over the capacitor array of the ADC.

A comparison phase is then begun at stage 509 by setting the MUX to select an n-bit threshold value *D_{THRESHOLD,i}* for any *i* from 0 to M, which is applied to the ADC capacitor array. All switches *Sᵢ,*where *i* is in the range from *0* to *n-1,* which receive '1' from the *D_{THRESHOLD,i}* word, are connected to reference voltage *V_{REF} at* stage 511 and the remaining switches are connected to a common mode voltage *V_{CM}* at stage 513. In this way, the output *VP* of the ADC reaches a value equal to the input voltage *V_{IN}* subtracted from the analog of *D_{THRESHOLD,0}.* The comparison to *V_{CM}* by the comparator is then completed at stage 515 upon the rising edge of the comparator clock input CK, such that if VP > *V_{CM},* then DP is 1 and the sample of *V_{IN}* is larger than *D_{THRESHOLD,0},* and otherwise, if VP < *V_{CM},* then DP is 0 and the sample of *V_{IN}* is smaller than *D_{THRESHOLD.0}.* If the comparison result reaches the trigger threshold at stage 517, a full SAR conversion is executed at stage 519, yielding the ADC output word *Dₒᵤₜ.* Otherwise, another threshold value *D_{THRESHOLD,j},* is selected, where j is in the range from *1* to M, and the comparison phase is repeated until all M threshold values have been compared. After any comparison between *Vᵢₙ* and *D_{threshold,i}* , and as a consequence of the comparison, a full SAR conversion is carried out to obtain a full resolution quantization of the input voltage.

## Claims

1. A method of analog-to-digital conversion in a sensor circuit with an input of *V_{IN}* and having an analog-to-digital converter, ADC, with a capacitor array comprising a plurality of capacitors connected through a respective plurality of switches, collectively forming a DAC, a comparator, a successive- approximation-register, SAR, module and a multiplexer, MUX, connected between the DAC and the SAR module, the method comprising:
executing a track phase when a sample clock signal CK_SMP is low by applying an input voltage *V_{IN}* over all capacitors in the capacitor array of the DAC;
executing a sampling phase on a subsequent rising edge of CK_SMP by opening the respective plurality of switches such that a sample of *V_{IN}* is stored over the capacitor array of the DAC;
executing a comparison phase, by setting the MUX to select an n-bit threshold value *D_{THRESHOLD.0}* which is applied to the DAC capacitor array, connecting all switches *Sᵢ*, where *i* is in the range from *0* to *n-1,* which receive 1, to a reference voltage *V_{REF}* and connecting the remaining switches to a common mode voltage *V_{CM}* such that the output *VP* of the DAC reaches a value equal to the input voltage *V_{IN}* subtracted from the analog of *D_{THRESHOLD.0},* and completing the comparison to *V_{CM}* by the comparator at the comparator clock CK, such that if VP > *V_{CM},* then DP is 1 and the sample of *V_{IN}* is larger than *D_{THRESHOLD,0},* and otherwise, if VP < *V_{CM},* then DP is 0 and the sample of *V_{IN}* is smaller than *D_{THRESHOLD, 0}*; wherein the result DP of the comparison is then used as a threshold trigger, and if the comparison reaches the trigger threshold, a full SAR conversion is executed,
and wherein, if the comparison does not reach the trigger threshold,
another threshold value *D_{THRESHOLD,j},* is selected, where j is in the range from *1* to M, via the MUX and the comparison phase is repeated until all M threshold values have been compared, wherein after any number of comparisons and based on the results of the corresponding threshold conversions a full SAR comparison is carried out to obtain a full quantization of the input voltage.

2. The method in accordance with claim 1, further comprising using *D_{THRESHOLD,1}* as an offset *D_{OFFSET.1}* away from the threshold *D_{THRESHOLD,0},* and updating *D_{THRESHOLD,1}* with *D_{OFFSET,1}* + *D_{THRESHOLD,0}.*

3. The method in accordance with claim 2, further comprising using *D_{THRESHOLD,2}* as an offset *D_{OFFSET,2}* away from *D_{THRESHOLD,0},* and updating *D_{THRESHOLD,2}* with *D_{OFFSET,2} + D_{THRESHOLD,0}* when *D_{THRESHOLD,0}*.

4. The method in accordance with claim 3, wherein *D_{OFFSET,2} ≠ D_{OFFSET,1}.*

5. A sensor system comprising a sensor circuit with an input of *V_{IN}* and having an analog-to-digital converter, ADC, with a capacitor array comprising a plurality of capacitors connected through a respective plurality of switches, collectively forming a DAC, a comparator, a successive- approximation-register, SAR, module and a multiplexer, MUX, connected between the DAC and the SAR module, the sensor system including a processor configured to execute a method of analog-to-digital conversion in the sensor circuit, the processor being configured to execute the method by:
executing a track phase when a sample clock signal CK_SMP is low by applying an input voltage *V_{IN}* over all capacitors in the capacitor array of the DAC;
executing a sampling phase on a subsequent rising edge of CK_SMP by opening the respective plurality of switches such that a sample of *V_{IN}* is stored over the capacitor array of the DAC;
executing a comparison phase, by setting the MUX to select an n-bit threshold value *D_{THRESHOLD.0}* which is applied to the DAC capacitor array, connecting all switches *Sᵢ,*where *i* is in the range from *0* to *n-1,* which receive 1, to a reference voltage *V_{REF}* and connecting the remaining switches to a common mode voltage *V_{CM}* such that the output *VP* of the DAC reaches a value equal to the input voltage *V_{IN}* subtracted from the analog of *D_{THRESHOLD.0},* and completing the comparison to *V_{CM}* by the comparator at the comparator clock CK, such that if VP > *V_{CM},* then DP is 1 and the sample of *V_{IN}* is larger than *D_{THRESHOLD,0},* and otherwise, if VP < *V_{CM},* then DP is 0 and the sample of *V_{IN}* is smaller than *D_{THRESHOLD,0}*; wherein the result DP of the comparison is then used as a threshold trigger, and if the comparison reaches the trigger threshold, a full SAR conversion is executed,and wherein, if the comparison does not reach the trigger threshold,
another threshold value *D_{THRESHOLD,j},* is selected where j is in the range from *1* to M, via the MUX and the comparison phase is repeated until all M threshold values have been compared, wherein after any number of comparisons and based on the results of the corresponding threshold conversions a full SAR comparison is carried out to obtain a full quantization of the input voltage.

6. The sensor system in accordance with claim 5, wherein the processor is further configured to use *D_{THRESHOLD,1}* as an offset *D_{OFFSET,1}* away from the threshold *D_{THRESHOLD,0},* and to update *D_{THRESHOLD,1}* with *D_{OFFSET},₁ + D_{THRESHOLD,0}.*

7. The sensor system in accordance with claim 6, wherein the processor is further configured to use *D_{THRESHOLD,2}* as an offset *D_{OFFSET,2}* away from *D_{THRESHOLD,0},* and to update *D_{THRESHOLD,}2* with *D_{OFFSET}, 2* + *D_{THRESHOLD,}0.*

8. The sensor system in accordance with claim 7, wherein *D_{OFFSET,2} ≠ D_{OFFSET,1}.*

9. A sensor circuit for executing analog-to-digital conversion, ADC, of a sensed value *V_{IN},* the sensor circuit comprising:
a DAC having a capacitor array comprising a plurality of capacitors connected through a respective plurality of switches;
a comparator;
a successive- approximation-register, SAR, module;
a multiplexer, MUX, connected between the DAC and the SAR module; and
a controller configured to execute a track phase when a sample clock signal CK SMP is low by applying an input voltage *V_{IN}* over all capacitors in the capacitor array of the DAC, execute a sampling phase on a subsequent rising edge of CK_SMP by opening the respective plurality of switches such that a sample of *V_{IN}* is stored over the capacitor array of the ADC, execute a comparison phase, by setting the MUX to select an n-bit threshold value *D*_{*THRESHOLD,*0} which is applied to the DAC capacitor array, connect all switches *Sᵢ,* where *i* is in the range from *0* to *n-1,* which receive 1, to a reference voltage *V_{REF},* and connect the remaining switches to a common mode voltage *V_{CM}* such that the output *VP* of the DAC reaches a value equal to the input voltage *V_{IN}* subtracted from the analog of *D_{THRESHOLD,0},* complete the comparison to *V_{CM}* by the comparator at the comparator clock CK, such that if VP > *V_{CM},* then DP is 1 and the sample of *V_{IN}* is larger than *D_{THRESHOLD,0},* and otherwise, if VP < *V_{CM},* then DP is 0 and the sample of *V_{IN}* is smaller than *D_{THRESHOLD}*, *₀*, wherein the result DP of the comparison is then used as a threshold trigger, if the comparison reaches the trigger threshold, a full SAR conversion is executed,
and wherein, if the comparison does not reach the trigger threshold, the controller is configured to select another threshold value *D_{THRESHOLD,j},* where j is in the range from *1* to *M*, via the MUX, and to repeat the comparison phase until all M threshold values have been compared, wherein after any number of comparisons and based on the results of the corresponding threshold conversions a full SAR comparison is carried out to obtain a full quantization of the input voltage.

## Patentansprüche

1. Ein Verfahren zur Analog-zu-Digital-Wandlung in einer Sensorschaltung mit einem Eingang von *V_{IN}* und mit einem Analog-zu-Digital-Wandler, ADC, mit einer Kondensatoranordnung, die eine Vielzahl von Kondensatoren umfasst, die über eine entsprechende Vielzahl von Schaltern verbunden sind, die zusammen einen DAC bilden, einem Komparator, einem Modul für ein Register mit sukzessiver Approximation, SAR, und einem Multiplexer, MUX, der zwischen dem DAC und dem SAR-Modul angeschlossen ist, wobei das Verfahren aufweist:
Ausführen einer Spurphase, wenn ein Abtasttaktsignal CK_SMP niedrig ist, indem eine Eingangsspannung *V_{IN}* über alle Kondensatoren in der Kondensatoranordnung des DAC angelegt wird;
Ausführen einer Abtastphase bei einer nachfolgenden ansteigenden Flanke von CK_SMP durch Öffnen der jeweiligen Vielzahl von Schaltern, so dass ein Abtastwert von *V_{IN}* über die Kondensatoranordnung des DAC gespeichert wird;
Ausführen einer Vergleichsphase, indem der MUX so eingestellt wird, dass er einen n-Bit-Schwellenwert *D_{THRESHOLD,0}* auswählt, der an die DAC-Kondensatoranordnung angelegt wird, Verbinden aller Schalter *Sᵢ,* wobei *i* im Bereich von 0 bis *n-1* liegt, die 1 empfangen, mit einer Referenzspannung *V_{REF}* und Verbinden der verbleibenden Schalter mit einer Gleichtaktspannung *V_{CM},* so dass der Ausgang *VP* des DAC einen Wert erreicht, der gleich der Eingangsspannung *V_{IN}* subtrahiert von dem Analogon von *D_{THRESHOLD,0},* ist, und Abschließen des Vergleichs mit *V_{CM}* durch den Komparator mit dem Komparatortakt CK, so dass, wenn VP > *V_{CM},* dann DP 1 ist und der Abtastwert von *V_{IN}* größer als *D_{THRESHOLD,0},* ist, und andernfalls, wenn VP < *V_{CM},* dann DP 0 ist und der Abtastwert von *V_{IN}* kleiner als *D_{THRESHOLD,0}* ist; wobei das Ergebnis DP des Vergleichs dann als ein Schwellenwert-Trigger verwendet wird, und wenn der Vergleich den Trigger-Schwellenwert erreicht, eine vollständige SAR-Wandlung ausgeführt wird, und wobei, wenn der Vergleich den Trigger-Schwellenwert nicht erreicht, ein anderer Schwellenwert *D_{THRESHOLD,j}* über den MUX ausgewählt wird, wobei j im Bereich von 1 bis *M* liegt, und die Vergleichsphase wiederholt wird, bis alle M Schwellenwerte verglichen worden sind, wobei nach einer beliebigen Anzahl von Vergleichen und basierend auf den Ergebnissen der entsprechenden Schwellenwert-Wandlungen ein vollständiger SAR-Vergleich ausgeführt wird, um eine vollständige Quantisierung der Eingangsspannung zu erhalten.

2. Das Verfahren nach Anspruch 1, weiter aufweisend die Verwendung von *D_{THRESHOLD,1}* als Offset *D_{OFFSET,1}* entfernt von dem Schwellenwert *D_{THRESHOLD,0},* und die Aktualisierung von *D_{THRESHOLD,1}* mit *D_{OFFSET,1}* + *D_{THRESHOLD,0}.*

3. Das Verfahren nach Anspruch 2, weiter aufweisend die Verwendung von *D_{THRESHOLD,2}* als Offset *D_{OFFSET,2}* entfernt von *D_{THRESHOLD,0},* und die Aktualisierung von *D_{THRESHOLD,2}* mit *D_{OFFSET,2}* + *D_{THRESHOLD,0},* wenn *D_{THRESHOLD,0}.*

4. Das Verfahren nach Anspruch 3, wobei *D_{OFFSET,2} ≠ D_{OFFSET,1}.*

5. Ein Sensorsystem, das eine Sensorschaltung mit einem Eingang von *V_{IN}* und mit einem Analog-zu-Digital-Wandler, ADC, mit einer Kondensatoranordnung, die eine Vielzahl von Kondensatoren umfasst, die über eine entsprechende Vielzahl von Schaltern verbunden sind, die zusammen einen DAC bilden, einem Komparator, einem Modul für ein Register mit sukzessiver Approximation, SAR, und einem Multiplexer, MUX, der zwischen dem DAC und dem SAR-Modul angeschlossen ist, aufweist, wobei das Sensorsystem einen Prozessor aufweist, der dazu eingerichtet ist, ein Verfahren zur Analog-zu-Digital-Wandlung in der Sensorschaltung auszuführen, wobei der Prozessor dazu eingerichtet ist, das Verfahren auszuführen, indem:
Ausführen einer Spurphase, wenn ein Abtasttaktsignal CK_SMP niedrig ist, indem eine Eingangsspannung *V_{IN}* über alle Kondensatoren in der Kondensatoranordnung des DAC angelegt wird;
Ausführen einer Abtastphase bei einer nachfolgenden ansteigenden Flanke von CK_SMP durch Öffnen der jeweiligen Vielzahl von Schaltern, so dass ein Abtastwert von *V_{IN}* über die Kondensatoranordnung des DAC gespeichert wird;
Ausführen einer Vergleichsphase, indem der MUX so eingestellt wird, dass er einen n-Bit-Schwellenwert *D_{THRESHOLD,0}* auswählt, der an die DAC-Kondensatoranordnung angelegt wird, Verbinden aller Schalter *Sᵢ,* wobei *i* im Bereich von 0 bis *n-1* liegt, die 1 empfangen, mit einer Referenzspannung *V_{REF}* und Verbinden der verbleibenden Schalter mit einer Gleichtaktspannung *V_{CM},* so dass der Ausgang *VP* des DAC einen Wert erreicht, der gleich der Eingangsspannung *V_{IN}* subtrahiert von dem Analogon von *D_{THRESHOLD,0},* ist, und Abschließen des Vergleichs mit *V_{CM}* durch den Komparator mit dem Komparatortakt CK, so dass, wenn VP > *V_{CM},* dann DP 1 ist und der Abtastwert von *V_{IN}* größer als *D_{THRESHOLD,0},* ist, und andernfalls, wenn VP < *V_{CM},* dann DP 0 ist und der Abtastwert von *V_{IN}* kleiner als *D_{THRESHOLD,0},* ist; wobei das Ergebnis DP des Vergleichs dann als ein Schwellenwert-Trigger verwendet wird, und wenn der Vergleich den Trigger-Schwellenwert erreicht, eine vollständige SAR-Wandlung ausgeführt wird, und wobei, wenn der Vergleich den Trigger-Schwellenwert nicht erreicht, ein anderer Schwellenwert *D_{THRESHOLD,j},* über den MUX ausgewählt wird, wobei *j* im Bereich von *1* bis *M* liegt, und die Vergleichsphase wiederholt wird, bis alle M Schwellenwerte verglichen worden sind, wobei nach einer beliebigen Anzahl von Vergleichen und basierend auf den Ergebnissen der entsprechenden Schwellenwert-Wandlungen ein vollständiger SAR-Vergleich ausgeführt wird, um eine vollständige Quantisierung der Eingangsspannung zu erhalten.

6. Das Sensorsystem nach Anspruch 5, wobei der Prozessor dazu eingerichtet ist, *D_{THRESHOLD,1}* als einen Offset *D_{OFFSET.1}* entfernt von dem Schwellenwert *D_{THRESHOLD,0},* zu verwenden, und *D_{THRESHOLD,1}* mit *D_{OFFSET.1}* + *D*_{*THRESHOLD,*0} zu aktualisieren.

7. Das Sensorsystem nach Anspruch 6, wobei der Prozessor dazu eingerichtet ist, *D_{THRESHOLD,2}* als einen Offset *D_{OFFSET,2}* entfernt von *D*_{*THRESHOLD,*0} zu verwenden, und *D_{THRESHOLD,2}* mit *D_{OFFSET,2}* + *D_{THRESHOLD,0},* wenn *D_{THRESHOLD,0},* zu aktualisieren.

8. Das Sensorsystem nach Anspruch 7, wobei *D_{OFFSET,2} ≠ D_{OFFSET,1}.*

9. Eine Sensorschaltung zur Ausführung einer Analog-zu-Digital-Wandlung, ADC, eines abgetasteten Wertes *V_{IN},* wobei die Sensorschaltung aufweist:
einen DAC mit einer Kondensatoranordnung, die eine Vielzahl von Kondensatoren umfasst, die über eine entsprechende Vielzahl von Schaltern verbunden sind;
einen Komparator;
ein Modul für ein Register mit sukzessiver Approximation (SAR);
einen Multiplexer, MUX, der zwischen dem DAC und dem SAR-Modul angeschlossen ist; und
einen Controller, der dazu eingerichtet ist, eine Spurphase auszuführen, wenn ein Abtasttaktsignal CK_SMP niedrig ist, indem eine Eingangsspannung *V_{IN}* über alle Kondensatoren in der Kondensatoranordnung des DAC angelegt wird, eine Abtastphase bei einer nachfolgenden ansteigenden Flanke von CK_SMP durch Öffnen der jeweiligen Vielzahl von Schaltern auszuführen, so dass ein Abtastwert von *V_{IN}* über die Kondensatoranordnung des ADC gespeichert wird, eine Vergleichsphase auszuführen, indem der MUX so eingestellt wird, dass er einen n-Bit-Schwellenwert *D_{THRESHOLD,0}* auswählt, der an die DAC-Kondensatoranordnung angelegt wird, alle Schalter *Sᵢ,* wobei *i* im Bereich von *0* bis *n-1* liegt und 1 empfängt, mit einer Referenzspannung *V_{REF}* zu verbinden und die verbleibenden Schalter mit einer Gleichtaktspannung *V_{CM}* zu verbinden, so dass der Ausgang *VP* des DAC einen Wert erreicht, der gleich der Eingangsspannung *V_{IN}* subtrahiert von dem Analogwert *D_{THRESHOLD,0},* ist, den Vergleich mit *V_{CM}* durch den Komparator mit dem Komparatortakt CK abzuschließen, so dass, wenn VP > *V_{CM}* ist, dann DP 1 ist und der Abtastwert von *V_{IN}* größer als *D_{THRESHOLD.0}* ist, und andernfalls, wenn VP < *V_{CM}* ist, dann DP 0 ist und der Abtastwert von *V_{IN}* kleiner als *D_{THRESHOLD,0}* ist, wobei das Ergebnis DP des Vergleichs dann als Schwellenwert-Trigger verwendet wird, wenn der Vergleich den Trigger-Schwellenwert erreicht, wird eine vollständige SAR-Wandlung ausgeführt, und wobei, wenn der Vergleich den Trigger-Schwellenwert nicht erreicht, der Controller dazu eingerichtet ist, über den MUX einen anderen Schwellenwert *D_{THRESHOLD,j}* auszuwählen, *wobei j* im Bereich von 1 bis Mliegt, und die Vergleichsphase zu wiederholen, bis alle M Schwellenwerte verglichen worden sind, wobei nach einer beliebigen Anzahl von Vergleichen und basierend auf den Ergebnissen der entsprechenden Schwellenwert-Wandlungen ein vollständiger SAR-Vergleich durchgeführt wird, um eine vollständige Quantisierung der Eingangsspannung zu erhalten.

## Revendications

1. Procédé de conversion analogique-numérique dans un circuit de capteur avec une entrée de *V_{IN}* et présentant un convertisseur analogique-numérique, ADC, avec un réseau de condensateurs comprenant une pluralité de condensateurs respective connectés par l'intermédiaire d'une pluralité de commutateurs, formant collectivement un DAC, un comparateur, un module de registre à approximations successives, SAR, et un multiplexeur, MUX, connecté entre le DAC et le module de SAR, le procédé comprenant :
l'exécution d'une phase de suivi lorsqu'un signal d'horloge d'échantillon CK_SMP est faible par application d'une tension d'entrée *V_{IN}* sur tous les condensateurs dans le réseau de condensateurs du DAC ;
l'exécution d'une phase d'échantillonnage sur un front montant subséquent de CK_SMP par ouverture de la pluralité de commutateurs respective de telle sorte qu'un échantillon de *V_{IN}* est stocké sur le réseau de condensateurs du DAC ;
l'exécution d'une phase de comparaison, par réglage du MUX pour sélectionner une valeur de seuil à n-bit *D*_{*THRESHOLD,*0} qui est appliquée au réseau de condensateurs DAC, connexion de tous les commutateurs *Sᵢ,* où *i* est dans la plage de *0* à *n-1,* qui reçoivent 1, à une tension de référence *V_{REF}* et connexion des commutateurs restants à une tension de mode commun *V_{CM}* de telle sorte que la sortie *VP* du DAC atteigne une valeur égale à la tension d'entrée *V_{IN}* soustraite de l'analogique de *D_{THRESHOLD.0},* et achèvement de la comparaison à *V_{CM}* par le comparateur au niveau de l'horloge de comparateur CK, de telle sorte que si VP > *V_{CM},* alors DP est 1 et l'échantillon de *V_{IN}* est supérieur à *D_{THRESHOLD,0},* et sinon, si VP < *V_{CM},* alors DP est 0 et l'échantillon de *V_{IN}* est inférieur à *D_{THRESHOLD.0}* ; dans lequel le résultat DP de la comparaison est alors utilisé comme déclencheur de seuil, et si la comparaison atteint le seuil de déclencheur, une conversion de SAR complète est exécutée, et dans lequel, si la comparaison n'atteint pas le seuil de déclencheur, une autre valeur de seuil *D_{THRESHOLD,j},* est sélectionnée, où *j* est dans la plage de *1* à *M,* par le biais du MUX et la phase de comparaison est répétée jusqu'à ce que toutes les M valeurs de seuil aient été comparées, dans lequel après n'importe quel nombre de comparaisons et sur la base des résultats des conversions de seuil correspondantes une comparaison de SAR complète est réalisée pour obtenir une quantification complète de la tension d'entrée.

2. Procédé selon la revendication 1, comprenant en outre l'utilisation de *D_{THRESHOLD,1}* comme décalage *D_{OFFSET.1}* du seuil *D_{THRESHOLD,0},* et la mise à jour de *D_{THRESHOLD,1}* avec *D_{OFFSET,1}* + *D_{THRESHOLD,0}.*

3. Procédé selon la revendication 2, comprenant en outre l'utilisation de *D_{THRESHOLD,2}* comme décalage *D_{OFFSET,2}* de *D_{THRESHOLD,0},* et la mise à jour de *D_{THRESHOLD,2}* avec *D_{OFFSET,2} + D_{THRESHOLD,0}* lorsque *D_{THRESHOLD,0}.*

4. Procédé selon la revendication 3, dans lequel *D_{OFFSET,2} ≠ D_{OFFSET,1}.*

5. Système de capteur comprenant un circuit de capteur avec une entrée de *V_{IN}* et présentant un convertisseur analogique-numérique, ADC, avec un réseau de condensateurs comprenant une pluralité de condensateurs respective connectés par l'intermédiaire d'une pluralité de commutateurs, formant collectivement un DAC, un comparateur, un module de registre à approximations successives, SAR, et un multiplexeur, MUX, connecté entre le DAC et le module de SAR, le système de capteur comportant un processeur configuré pour exécuter un procédé de conversion analogique-numérique dans le circuit de capteur, le processeur étant configuré pour exécuter le procédé par :
exécution d'une phase de suivi lorsqu'un signal d'horloge d'échantillon CK_SMP est faible par application d'une tension d'entrée *V_{IN}* sur tous les condensateurs dans le réseau de condensateurs du DAC ;
exécution d'une phase d'échantillonnage sur un front montant subséquent de CK_SMP par ouverture de la pluralité de commutateurs respective de telle sorte qu'un échantillon de *V_{IN}* est stocké sur le réseau de condensateurs du DAC ;
exécution d'une phase de comparaison, par réglage du MUX pour sélectionner une valeur de seuil à n-bit *D*_{*THRESHOLD,*0} qui est appliquée au réseau de condensateurs DAC, connexion de tous les commutateurs *Sᵢ,* où *i* est dans la plage de *0* à *n-1,* qui reçoivent 1, à une tension de référence *V_{REF}* et connexion des commutateurs restants à une tension de mode commun *V_{CM}* de telle sorte que la sortie *VP* du DAC atteigne une valeur égale à la tension d'entrée *V_{IN}* soustraite de l'analogique de *D_{THRESHOLD,0},* et achèvement de la comparaison à *V_{CM}* par le comparateur au niveau de l'horloge de comparateur CK, de telle sorte que si VP > *V_{CM},* alors DP est 1 et l'échantillon de *V_{IN}* est supérieur à *D_{THRESHOLD,0},* et sinon, si VP < *V_{CM},* alors DP est 0 et l'échantillon de *V_{IN}* est inférieur à *D_{THRESHOLD.0}* ; dans lequel le résultat DP de la comparaison est alors utilisé comme déclencheur de seuil, et si la comparaison atteint le seuil de déclencheur, une conversion de SAR complète est exécutée, et dans lequel, si la comparaison n'atteint pas le seuil de déclencheur, une autre valeur de seuil *D_{THRESHOLD,j},* est sélectionnée, où *j* est dans la plage de *1* à *M,* par le biais du MUX et la phase de comparaison est répétée jusqu'à ce que toutes les M valeurs de seuil aient été comparées, dans lequel après n'importe quel nombre de comparaisons et sur la base des résultats des conversions de seuil correspondantes une comparaison de SAR complète est réalisée pour obtenir une quantification complète de la tension d'entrée.

6. Système de capteur selon la revendication 5, dans lequel le processeur est en outre configuré pour utiliser *D_{THRESHOLD,1}* comme décalage *D_{OFFSET.1}* du seuil *D_{THRESHOLD,0},* et pour mettre à jour *D_{THRESHOLD.1}* avec *D_{OFFSET,1}* + *D_{THRESHOLD,0}.*

7. Système de capteur selon la revendication 6, dans lequel le processeur est en outre configuré pour utiliser *D_{THRESHOLD,2}* comme décalage *D_{OFFSET,2}* de *D_{THRESHOLD,0},* et pour mettre à jour *D_{THRESHOLD,2}* avec *D_{OFFSET,2} + D_{THRESHOLD,0}* lorsque *D_{THRESHOLD,0}.*

8. Système de capteur selon la revendication 7, dans lequel *D_{OFFSET,2} ≠ D_{OFFSET,1}.*

9. Circuit de capteur pour exécuter une conversion analogique-numérique, ADC, d'une valeur *V_{IN}* détectée, le circuit de capteur comprenant :
un DAC présentant un réseau de condensateurs comprenant une pluralité de condensateurs connectés par l'intermédiaire d'une pluralité de commutateurs respective ;
un comparateur ;
un module de registre d'approximations successives, SAR ;
un multiplexeur, MUX, connecté entre le DAC et le module de SAR ; et
un dispositif de commande configuré pour exécuter une phase de suivi lorsqu'un signal d'horloge d'échantillon CK_SMP est faible par application d'une tension d'entrée *V_{IN}* sur tous les condensateurs dans le réseau de condensateurs du DAC, exécuter une phase d'échantillonnage sur un front montant subséquent de CK_SMP par ouverture de la pluralité de commutateurs respective de telle sorte qu'un échantillon de *V_{IN}* est stocké sur le réseau de condensateurs du ADC, exécuter une phase de comparaison, par réglage du MUX pour sélectionner une valeur de seuil à n-bit *D*_{*THRESHOLD,*0} qui est appliquée au réseau de condensateurs DAC, connecter tous les commutateurs *Sᵢ,* où *i* est dans la plage de *0* à *n-1,* qui reçoivent 1, à une tension de référence *V_{REF},* et connecter les commutateurs restants à une tension de mode commun *V_{CM}* de telle sorte que la sortie *VP* du DAC atteigne une valeur égale à la tension d'entrée *V_{IN}* soustraite de l'analogique de *D_{THRESHOLD,0},* achever la comparaison à *V_{CM}* par le comparateur au niveau de l'horloge de comparateur CK, de telle sorte que si VP > *V_{CM},* alors DP est 1 et l'échantillon de *V_{IN}* est supérieur à *D_{THRESHOLD,0},* et sinon, si VP < *V_{CM},* alors DP est 0 et l'échantillon de *V_{IN}* est inférieur à *D_{THRESHOLD,0},* dans lequel le résultat DP de la comparaison est alors utilisé comme déclencheur de seuil, si la comparaison atteint le déclencheur de seuil, une conversion de SAR complète est exécutée, et dans lequel, si la comparaison n'atteint pas le seuil de déclencheur, le dispositif de commande est configuré pour sélectionner une autre valeur de seuil *D_{THRESHOLD,j},* où *j* est dans la plage de *1 à M,* par le biais du MUX, et pour répéter la phase de comparaison jusqu'à ce que toutes les M valeurs de seuil aient été comparées, dans lequel après n'importe quel nombre de comparaisons et sur la base des résultats des conversions de seuil correspondantes une comparaison de SAR complète est réalisée pour obtenir une quantification complète de la tension d'entrée.
